# EUROPEAN PATENT APPLICATION

(11) **EP 2 190 043 A1**
(43) Date of publication of application: **26.05.2010**
(21) Application number: 08169545.4
(22) Date of filing: 20.11.2008
(51) Int. Cl.: H01L 51/52

(54) **Electronic device and method to manufacture an electronic device**

(71) Applicant: Nederlandse Organisatie voor Toegepast- Natuurwetenschappelijk Onderzoek TNO, 2628 VK The Hague (NL)
(72) Inventor: van Mol, Antonius Maria Bernardus, 5658 HC Eindhoven (NL)
(74) Representative: Hatzmann, Martin

(57) **Abstract**

Electronic device (1), comprising a functional structure (10) protected by at least one barrier structure (20) comprising a first inorganic layer (21), an organic layer (22) and a second inorganic layer (23) facing the functional structure (10), the organic layer (22) being arranged between the first and the second inorganic layer (21, 23), the barrier structure (20) being provided with at least one recess (24) wherein a getter material (30) is submerged, the getter material (30) being separated from the organic layer (22) by the second inorganic layer (23).

## Description

### BACKGROUND OF THE INVENTION

### Field of the invention

The present invention relates to an electronic device.

The present invention further relates to a method to manufacture an electronic device.

### Related Art

Opto-electronic devices, such as organic light-emitting diodes (OLEDs), solar cells, electrochromic devices, need to be protected from moisture form the environment. The conventional solution to seal for example OLED devices has been with a glass or metal lid using an epoxy resin. Substances like water and oxygen may damage the components of the organic device. These harmful substances may penetrate the package during use or may have entered the package during manufacturing. Accordingly, a getter material such as CaO is often incorporated within the package to eliminate such harmful substances. However, this standard solution is insufficient or problematic for flexible OLEDs where the ability to conform or flex the device is essential. In the case of flexible OLEDs, thin film barriers consisting of inorganic and sometimes inorganic/organic multi-layers are usually used for encapsulation on both sides.

US2005/0045900 describes an organic electronic device structure that comprises:
- a first portion comprising a substrate and an organic electronic device region (e.g., an OLED region) disposed over the substrate;
- a second portion comprising a cover and a getter region; and
- a radiation-curable, pressure-sensitive adhesive layer disposed between the first and second portions and adhering the first and second portions to one another. The adhesive layer is disposed over the entire organic electronic device region and over at least a portion of the substrate.

The substrate and the cover can be made from a composite material layer, for example a thin oxide layer deposited over the OLED, followed by a planarizing sub-layer, e.g., a polymer layer, followed by another high-density (e.g., oxide) sub-layer.

The getter region can be disposed within the device structure in a variety of configurations. For example, in some embodiments, the getter region is provided in the form of a continuous region, while in other embodiments, the getter region comprises two or more distinct regions. As another example, the getter region in some embodiments is provided on a surface of the cover, while in other embodiments, the getter region is provided within one or more grooves that are formed in the cover.

According to the cited document the adhesive layer is essential for the reason that certain getter materials produce potentially harmful byproducts (e.g., acids) upon reacting with gaseous species from the outside environment (e.g., water). By covering the entire organic electronic device region with adhesive, the organic electronic device region is isolated from such harmful species, allowing the getter region to be positioned in close proximity to the organic electronic device region. It is further stated in the cited document that even if the getter material utilized does not produce potentially harmful byproducts, when dealing with a flexible device, the presence of a narrow air gap between the getter and the organic electronic device region affords little to no protection of the organic electronic device region during flexing, and damage to the organic electronic device region can occur due to contact between the organic electronic device region and the getter. By covering the entire organic electronic device region with adhesive, however, undesirable contact between the getter and the organic electronic device region is minimized, thereby protecting the organic electronic device region from such damage.

It is however a disadvantage of the adhesive layer that it also hinders the above-mentioned harmful substances to flow towards the getter, and therewith reduces the efficiency of the getter. Furthermore it is noted that some getters may expand during absorption of the substances to be gettered. This will result in the building of a pressure inside the device. Accordingly there is a need for a flexible organic electronic device that allows for an improved transport of harmful substances towards the getter, while preventing that the getter contacts the organic electronics device region when flexing the device, which allows free expansion of the gettered material without causing stress built-up leading to cracking of the device.

### SUMMARY OF THE INVENTION

According to an aspect of the invention there is provided an electronic device, comprising a functional structure protected by at least one barrier structure comprising a first inorganic layer, an organic layer and a second inorganic layer facing the functional structure, the organic layer being arranged between the first and the second inorganic layer, the barrier structure being provided with at least one recess wherein a getter material is submerged, the getter material being separated from the organic layer by the second inorganic layer.

In the electronic device according to the present invention, the getter material is present close to the functional structure, so that moisture that penetrates to the functional structure can still be absorbed. However, as the getter material is submerged in the at least one recess formed in the barrier structure, the getter material is not in physical contact with the functional structure, even if the device is flexed. In the electronic device according to the present invention expansion of the getter material during absorption of the substances to be gettered does not result in building of a pressure, as the getter material being submerged into the recesses has room to expand. Although in general a combination of a first inorganic layer, an organic layer and a second inorganic layer has good barrier properties, the barrier structure may be extended with one or more additional layers, comprising alternating organic and inorganic layers. For example if an extremely long lifetime of the product is desired.

The electronic device is for example a light emitting diode (LED), a liquid crystal display (LCD), a photovoltaic article, a thin film battery, an electro chromic article, or an organic electroluminescent device (OELD). Usually, the functional structure is constructed as a stack of layers e.g. comprising electrodes, electron or hole transport layers, and an active structure that for example performs a conversion process (electro-optic or opto-electrical) or that has a physical property dependent on an electrical property, e.g. electrical storage, or an optical transmissivity or a reflectivity.

The functional structure may be encapsulated by the barrier structure, a substrate and a perimeter sealant material. Such an encapsulation is suitable, if the substrate is made of an inorganic material such as glass or a metal, which forms an effective barrier against moisture and other substances present in the atmosphere which may be detrimental to the functional structure. It is attractive if the electronic device is flexible. In that case a rigid substrate like glass or metal is not suitable.

An embodiment of the electronic device according to the invention comprises a further barrier structure arranged at a side of the functional structure opposite to the side of the barrier structure. The barrier structure and the further barrier structure are coupled together by a perimeter sealant. The barrier structure, the further barrier structure and the perimeter sealant encapsulate the functional structure. In this case it is not necessary that the substrate is an inorganic material, but also organic materials, which usually are more flexible can be used.

According to a further aspect of the invention, there is provided a method for manufacturing an electronic device, comprising the steps of
- providing at least one patterned barrier structure by the steps of
   - providing a first inorganic layer,
   - providing an organic layer having at least one recess,
   - providing a second inorganic layer at the organic layer,
- accommodating a getter material in a submerged manner into the at least one recess,
- providing a functional structure at the side of the barrier structure comprising the second inorganic layer.

According to this method the second inorganic layer is applied at the organic layer, which is already patterned with at least one recess. In this way a substantially continuous second inorganic layer is obtained. The getter material is applied in a submerged manner into the at least one recess. Accordingly, even if the manufactured electronic device is flexed, only the material of the cover contacts the functional structure, so that harmful effects due to a contact between the getter material and the functional structure are avoided. Protection by an additional adhesive layer is avoided, so that harmful substances in the presence of the functional structure can flow to the getter material unhindered.

### BRIEF DESCRIPTION OF THE DRAWINGS

These and other aspects are described in more detail with reference to the drawing. Therein:
Figure 1 shows a first embodiment of an electronic device according to the invention,
Figure 2 shows a cross-section according to II-II in Figure 1,
Figure 3 shows a detail of Figure 1,
Figure 4 shows a second embodiment of an electronic device according to the invention,
Figure 5A illustrates a first step of a method of manufacturing an electronic device according to the invention,
Figure 5B illustrates a second step of a method of manufacturing an electronic device according to the invention,
Figure 5C illustrates a third step of a method of manufacturing an electronic device according to the invention,
Figure 5D illustrates a fourth step of a method of manufacturing an electronic device according to the invention,
Figure 5E illustrates a fifth step of a method of manufacturing an electronic device according to the invention,
Figure 5F illustrates a sixth step of a method of manufacturing an electronic device according to the invention.

### DETAILED DESCRIPTION OF EMBODIMENTS

In the following detailed description numerous specific details are set forth in order to provide a thorough understanding of the present invention. However, it will be understood by one skilled in the art that the present invention may be practiced without these specific details. In other instances, well known methods, procedures, and components have not been described in detail so as not to obscure aspects of the present invention.

The invention is described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. In the drawings, the size and relative sizes of layers and regions may be exaggerated for clarity. Embodiments of the invention are described herein with reference to cross-section illustrations that are schematic illustrations of idealized embodiments (and intermediate structures) of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing. Thus, the regions illustrated in the figures are schematic in nature and their shapes are not intended to illustrate the actual shape of a region of a device and are not intended to limit the scope of the invention.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

Spatially relative terms, such as "beneath", "below", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein. In case of conflict, the present specification, including definitions, will control. In addition, the materials, methods, and examples are illustrative only and not intended to be limiting.

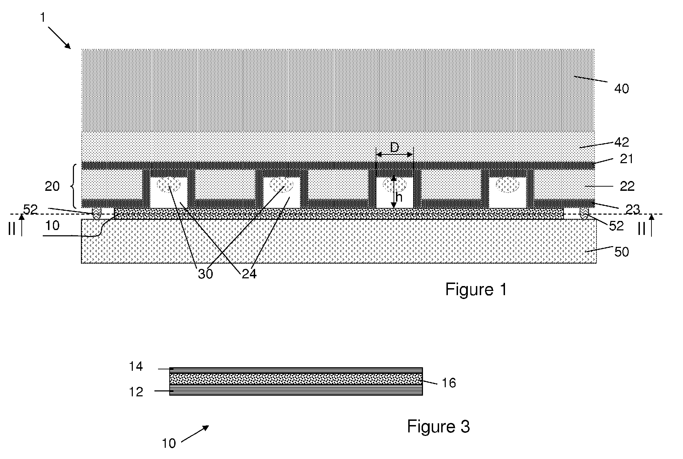

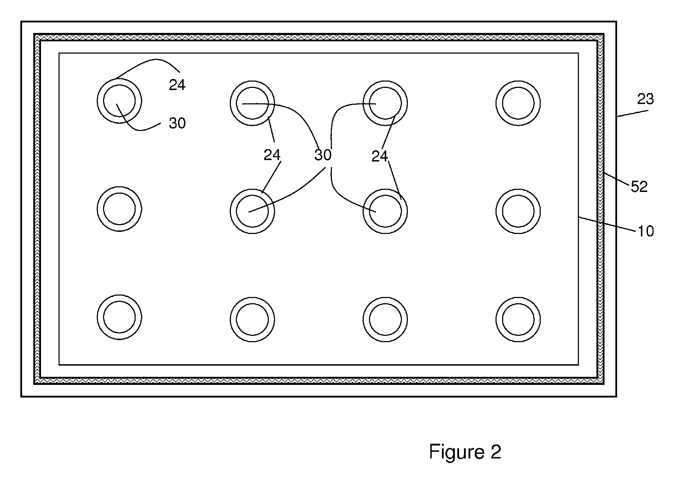

Figures 1 and 2 show an electronic device 1 according to the invention. Figure 2 shows a cross-section according to II-II in Figure 1. The electronic device comprises a functional structure 10 comprising one or more layers protected by at least one barrier structure 20 comprising a first inorganic layer 21, an organic layer 22 and a second inorganic layer 23 facing the functional structure 10, the organic layer 22 being arranged between the first and the second inorganic layer 21, 23, the barrier structure 20 being provided with at least one recess 24 wherein a getter material 30 is submerged. The getter material 30 is separated from the organic layer 22 by the second inorganic layer 23. The recesses 24 have depth h, and a diameter D. In a preferred embodiment the depth h may be in a range of 20-300 µm. If the depth of the recesses is substantially less than 20µm, for example 10µm, a relatively large number of recesses has to be filled to obtain a sufficiently amount of getter material with the space comprising the functional structure. Also, it is relatively difficult and therewith costly to achieve that the getter materials are submerged into the recesses with a depth substantially less than 10µm. If the depth is substantially more than 300 µm, for example 500 µm, it is relatively difficult and therewith costly to create the recesses. The diameter may be in a range of 100 to 500 µm, for example about 300 µm. If the diameter is substantially smaller than 100 µm, also the volume is small, and a relatively high number of recesses has to be filled to have a sufficient amount of getter material within the device. If the diameter is substantially larger, e.g. larger than 500 µm, then the structure formed by the recesses with the getter therein becomes clearly visible, which may be undesirable. In Figures 1 and 2, the diameter of the recesses 24 is exaggerated for clarity. The distance between the recesses may be in a range of 50 µm to 50 cm. A preferred value is about 1 cm.

It is not necessary that the recesses may have the form of pits. Alternatively the recesses may be formed as slits, grooves, trenches etc.

In the embodiment shown, the recesses have a depth corresponding to the thickness of the organic layer 22. In practice the depth will be less to guarantee a good decoupling between the inorganic layers 21 and 23.

The barrier structure 20 is applied via a planarization layer 42 at a substrate 40. The substrate is for example a polymer, such as a PET (Poly Ethylene Terephthalate) or PEN (Poly Ethylene Naphthalate) or PC (polycarbonate) layer. The latter materials are in particular suitable if transparency is desired, e.g. for top-emission type OLEDs, or for electro chromic devices The substrate may for example have a thickness of less than 250 µm, e.g. 125 or 50 µm. A substrate may even be absent in the finished product as is described in earlier Application P83333EP00, having European filing number 08151524.9. In that Application a manufacturing process is described for an organic device, wherein a substrate is removed after completion of the manufacturing process.

The inorganic layer(s) 21, 23 in the barrier structure 20 may include but are not limited to metals, ceramics, hydrogenated compounds and combinations thereof. Suitable metals can include but are not limited to Al, Ti, Ni, Cr. Ceramics can include but are not limited to metal oxide, such as indium oxide (In2O3), tin oxide (SnO2), indium tin oxide (ITO), silicon oxide (SiOₓ),a metal nitride, such as aluminium nitride (AIN), silicon nitride (SiN), a carbide, such as silicon carbide, a metal oxynitride, e.g. siliconoxynitride, or any other combination such as metal oxy carbides, metal carbonitrides, metal oxycarbonitrides. Hydrogenated compounds can include amorphous hydrogenated SiN (a-SiN:H), amorphous hydrogenated carbon (a-C:H), amorphous hydrogenated silicon carbide (a-SiC:H) and hydrogenated variants of above mentioned ceramic compounds. In case that the semi-finished product is intended for manufacturing an electronic device with an optical function a substantially transparent ceramic may be selected such as silicon oxide (SiO2), aluminum oxide (A12O3), titanium oxide (TiO2), indium oxide (In2O3), tin oxide (SnO2), indium tin oxide (ITO, In203+SnO2), (SiC), silicon oxynitride (SiON) and combinations thereof.

The first 21 and second 23 inorganic layer may have a thickness in a range between 10 and 5000 nm. By atomic layer deposition an already sufficiently tight layer may be achieved with a thickness of 10 nm. The moisture resistivity is further improved if the thickness is further increased. Above 5000 nm however no further improvement is obtained. Preferably the thickness of the inorganic layers 21 and 23 is in a range between 50 and 300 nm. From a thickness of 50 nm onwards sufficiently tight coatings can also be obtained with faster coating methods such as plasma coating and sputter technology. A thickness of at most 300 nm has the advantage that the product remains flexible.

The organic layer 22 in the barrier structure 20 may be provided from a cross-linked (thermoset) material, an elastomer, a linear polymer, or a branched or hyper-branched polymer system or any combination of the aforementioned, optionally filled with inorganic particles of a size small enough to still guarantee light transmission. The material is processed either from solution or as a 100% solids material. Curing or drying may exemplary occur by irradiation of the wet material, pure, or suitably formulated with a photo- or heat sensitive radical or super-acid initiator, with UV-light, visible light, infrared light or heat, E-beam, g-rays or any combination of the aforementioned. The material of the organic layer preferably has a low specific water vapor transmission rate and a high hydrophobicity.

Examples of suitable cross-linking (thermoset) systems are any single one or any combination of aliphatic or aromatic epoxy acrylates, urethane acrylates, polyester acrylates, polyether acrylates, saturated hydrocarbon acrylates, epoxides, epoxide-amine systems, epoxide-carboxylic acid combinations, oxetanes, vinyl ethers, vinyl derivatives, and thiol-ene systems. Suitable examples of elastomeric materials are polysiloxanes. Examples of suitable branched or linear polymeric systems are any single one or any copolymer or physical combination of polyacrylates, polyesters, polyethers, polypropylenes, polyethylenes, polybutadienes, polynorbornene, cyclic olefin copolymers, polyvinylidenefluoride, polyvinylidenechloride, polyvinylchloride, polytetrafluoroethylene, polychlorotrifluoroethylene, polyhexafluoropropylene.

Depending on the height of the getter material, the organic layer 22 may have a thickness in a range between 0.1 and 300 µm, preferably between 5 and 50 µm. Generally speaking a thinner organic layer provides for a longer diffusion path between the subsequent inorganic layers. On the other hand a thicker organic layer has the advantage of a better encapsulation of dust and other particles and therewith providing a better planarization for the next inorganic layer.

The functional structure 10 may lie against the second inorganic layer 23. Alternatively an air-gap may be present between the functional structure 10 and the second inorganic layer 23 to facilitate diffusion of substances towards the getter material 30. When bending the electronic device it may still occur that the functional structure 10 touches the second inorganic layer 23. As the getter material 30 is submerged in the recesses 24, there can be no harmful interaction between the getter material 30 and the functional structure 10, when the functional structure 10 touches the second inorganic layer 23, either permanently, or during bending of the device 1.

The functional structure 10 may be an electro-optical structure, which converts an electrical signal into (a change of) an optically detectable phenomenon, e.g. the electro-optical structure may convert an electrical current into (visible) radiation, or it may have a variable reflectivity or transmissivity as a function of a voltage applied thereto. Alternatively, the functional structure 10 may be an opto-electrical structure, which converts impingent radiation into an electrical signal.

Figure 3 shows an example of a functional structure 10. The functional structure 10 comprises a first transparent, electrically conductive layer 12, for example a layer of a transparent conducting metal oxide, e.g. a layer of indium tin oxide (ITO), zinc oxide (ZnO) or tin oxide (SnO). The first transparent, electrically conductive layer 12 has a thickness in the range of 50-300 nm, for example 150 nm. Alternatively or additionally a sufficiently conducting transparent organic material such as PEDOT may be used or a thin metal. The functional structure comprises a second electrically conductive, not necessarily transparent layer 14, e.g. a layer of Barium having a thickness of about 5 nm combined with a layer of aluminium having a thickness in the range of 100-400 nm.

The electrically conductive layers 12, 14 may be connected to respective external conductors in a way known to the skilled person. Preferably a connection is applied according to the earlier filed European Patent Application 08161840.7 filed by the same Applicant and corresponding to P84923EP00.

An active structure 16 is sandwiched between said first and second conductive layer 12, 14. Depending on its function, the active structure 16 may comprise one or more functional layers. For example in case that the electronic device is an OLED, the functional structure comprises at least one layer of an organic light emitting material, such as polymeric PPV or layer stacks and mixtures of small molecule including emitters such as IrPy. In addition the active structure may comprise a hole injection layer (HIL) between the layer of light emitting material and the electrically conductive layer forming the anode, and or an electron transport layer between the layer of light emitting material and the electrically conductive layer forming the cathode. Suitable materials are for example aluminium, copper or silver.

In case the electronic device is a photovoltaic cell, the active structure may comprise a combination of an electron-donating layer and an electron-accepting layer. For example the first conductive layer is an ITO layer having a thickness of 125 nm and the second conductive layer is an aluminium layer having a thickness of 100 nm, between which are arranged a pair of organic layers, e.g. a 75 nm PEDOT and a100 nm blend layer (MDMO-PPV: PCBM 1:4).

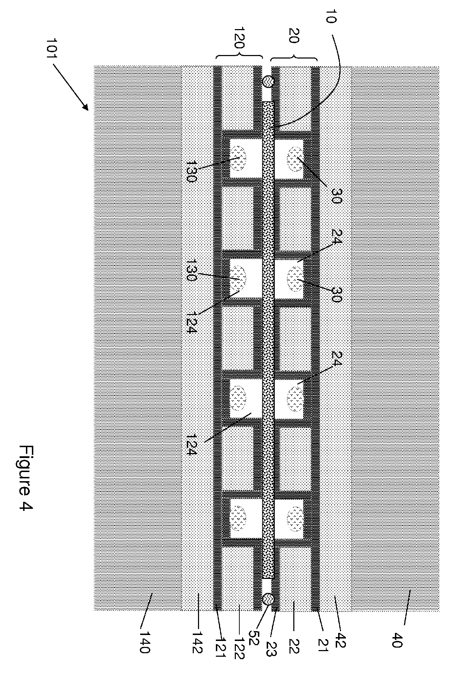

In the embodiment of Figure 1 and 2, the functional structure 10 is encapsulated by the barrier structure 20, the perimeter sealant 52 and the substrate 50. Such an encapsulation is suitable, if the substrate is made of an inorganic material such as glass or a metal. Such inorganic materials form an effective barrier against moisture and other substances present in the atmosphere, which may be detrimental to the functional structure. It is attractive if the electronic device is flexible. In that case a rigid substrate like glass is not suitable. However, a metal foil may be used. If both flexibility and transparency are required an embodiment as shown in Figure 4 may be used.

Figure 4 shows an embodiment of the electronic device according to the invention that comprises a further barrier structure 120 arranged at a side of the functional structure 10 opposite to the side of the barrier structure 20. Parts of the further barrier structure 120 corresponding to the barrier structure 20 have a reference number that is 100 higher. The barrier structure 20 and the further barrier structure 120 are coupled together by a perimeter sealant 52. The barrier structure 20, the further barrier structure 120 and the perimeter sealant 52 encapsulate the functional structure 10. In this case the substrate 140 can be a flexible material, such as a polymer, such as a PET (Poly Ethylene Terephthalate) or PEN (Poly Ethylene Naphthalate) or PC (polycarbonate) layer. The further barrier structure 120 is applied via a further planarization layer 142 at the substrate 140. In this embodiment the further barrier layer 120 is also provided with recesses 24 having a getter material 30 submerged therein.
A manufacturing process for an electronic device according to the invention will typically comprise multiple process steps such as for example unwinding and rewinding of foils, transferring of sheets of foil, slitting and lamination of foils, pretreatment of surfaces, coating of surfaces with an inorganic layer, coating of surfaces with an organic layer, coating of surfaces with a patterned organic layer, patterning of uniformly deposited coatings, curing of coatings.

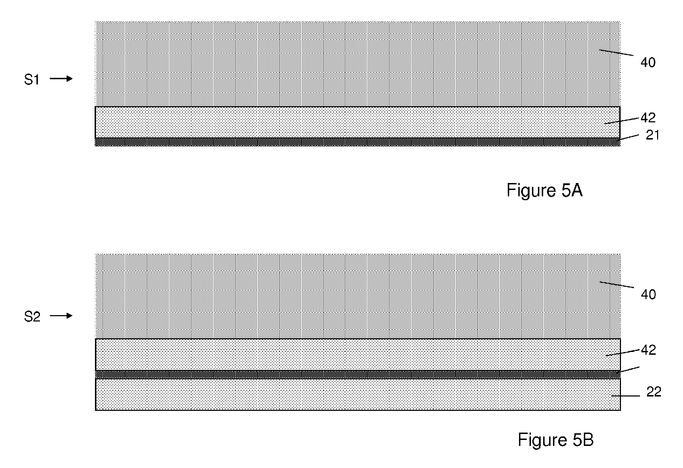

Key steps of a method of manufacturing an electronic device according to the invention are shown in Figure 5A-5F. In the steps S1 to S4, respectively shown in Figures 5A-5D a patterned barrier structure 20 is applied. In step S1, shown in Figure 5A, a first inorganic layer 21 of the barrier structure 20 is applied, here at a planarization layer 42 provided at a substrate 40.

The inorganic coating deposition process can be any process known in the art (physical vapor deposition, chemical vapor deposition, plasma deposition, solgel and others).

The substrate 40 facilitates the handling of the thin film based device under construction as it provides stiffness thereto. It may be desirable to remove the substrate 40 at a later manufacturing stage in order to improve flexibility of the (semi-finished) product. The substrate 40 may be selected from a variety of materials depending on whether it remains with the product and if so depending on the required stiffness of the product. If the substrate remains with the (semi finished) product and high flexibility is desired a substrate of a polymer, such as a PET (Poly Ethylene Terephthalate) or PEN (Poly Ethylene Naphthalate) or PC (polycarbonate) layer may be used. The substrate may for example have a thickness of less than 250 µm, e.g. 125 or 50 µm. Dependent on the application also other materials are suitable for the substrate. For example a metal foil may be used, if it is not necessary that the product is transparent, e.g. for batteries. A metal foil is also suitable as the substrate at the side of an OLED facing away from the radiation direction. Alternatively, if flexibility is not desired or if the substrate is removed from the (semi finished) product during the manufacturing process then alternatively a glass substrate may be used.

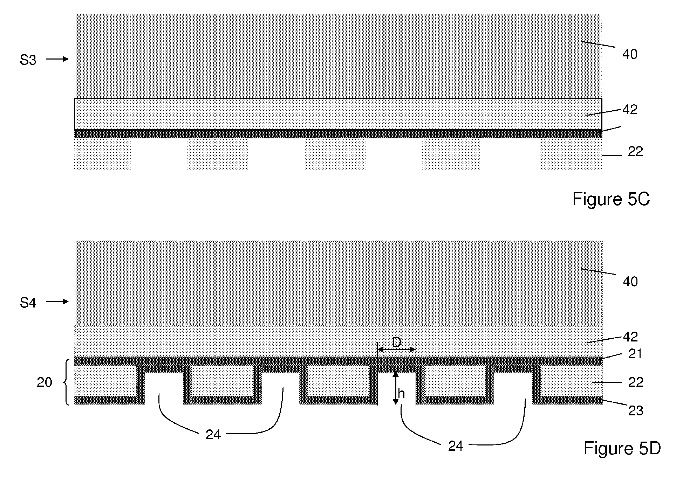

In a second step S2, shown in Figure 5B, an organic layer is 22 is applied. In step S3, as shown in Figure 5C the organic layer is patterned.

The organic coating deposition process can be any process known in the art with the capability of making a uniform and/or patterned deposition (gravure, flexo, inkjet, pad printing, transfer coating, physical vapor deposition, chemical vapor deposition, plasma deposition and others). The organic layer portions with the depressions therein can either be obtained by using a patterned deposition process that deposits organic layers only in those areas where the portions are intended to be present or by applying a post patterning process. For example the pattern depressions in the organic layer may be formed by soft lithography. In that case a stamp, for example a PDMS rubber stamp, is embossed into a partially reacted organic layer. Therewith depressions can be formed that can have an aspect ratio of up to 10. Alternatively other methods such as photolithography to produce the patterned organic decoupling layer directly or with anisotropic etching may be used.

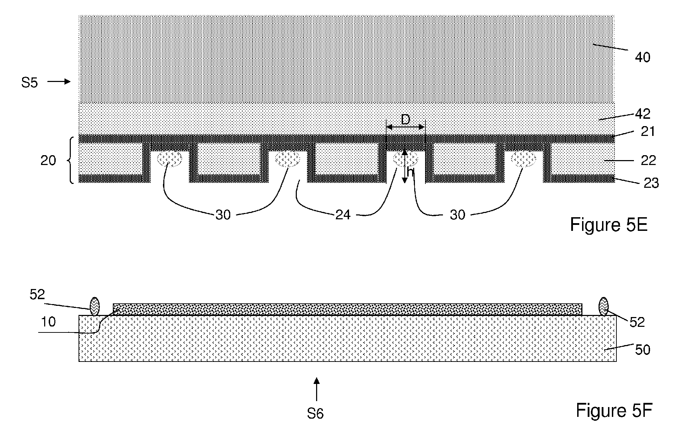

In step S4, as shown in Figure 5D, the second inorganic layer 23 is applied at the organic layer 22. The second organic layer 23 is applied so that an inorganic layer 23 conformal with the organic layer 22 is obtained.
In step S5, as shown in Figure 5E, a getter material 30 is accommodated in a submerged manner into the recesses. Preferably the getter material 30 is dispensed into the recesses by a printing method. The getter 30 in the recesses 24 of the barrier foil can be one or more thick film getters. These getters may include fine micron or nano sized particles of materials with high sorption capacity for water vapor an other gases such as 02, dispersed in curable organic binders. The thick film getter is deposited in the recesses 24 of the barrier structure 20 to a thickness range of 3 to 100 µm, but always less than the height of the recess, and preferably around 10 microns.

A syringe dispensing or a screen printing process may be used to deposit the thick film getter in the desired location. Examples of commercially available thick film getter materials are available from Cookson Electronics of Alpharetta, GA under the trade names STAYDRY SDlOOO and HICAP 2000. Other forms of thick film getters are discussed in US Patent Application Publication numbers 2006/0088663 and 2005/0104032 to Cho et al.

The thick film getter composition, as described herein, is bonded to substrate by depositing the thick film composition onto the substrate and curing the thick film. Depending on device structure and required performance, thickness of the getter film may be controlled by the sequential depositions of the paste. A typical thickness of the thick film getter after single printing and curing ranges from 10 µm to 30 µm.

Preferably however, the getter applied in the recesses is free from additives.
Various desiccant materials such as molecular sieves (or zeolites), alkaline earth metal oxides, metal oxides, sulfates, chlorides, bromides may be selected as the getter. Zeolites are particularly suitable. Zeolites are materials that absorb moisture by physical absorption and may be naturally or synthetically derived, both are suitable. Natural zeolites are hydrated silicate of aluminum and either sodium or calcium or both, of the type Na2O, Al2O3, xH2O, and xSiO2. Synthetic zeolites are made either by a gel process or a clay process, which forms a matrix to which the zeolite is added. Well known zeolites include chabazite (also referred to as zeolite D), clinoptilolite, erionite, faujasite (also referred to as zeolite X and zeolite Y), ferrierite, mordenite, zeolite A, and zeolite P. For example, type 3A, 4A and 13X zeolites all have the ability to adsorb water molecules. Such zeolites comprise Na2O, Al2O3 and SiO2. Certain adsorbent getters can adsorb gaseous contaminants in addition to moisture, such as gaseous H2 and 02.

If the recesses have a diameter that is sufficiently large the getter may be applied therein by a double sided tape. In that case, the depth of the recesses should be greater that the thickness of the double sided tape. Usually, such a tape has a thickness in the range of 25 to 50 µm. Furthermore the recesses should have a smallest lateral dimension of at least 250 µm to enable application of double sided tape.

Alternatively, an adhesive material may be applied in the recesses prior to applying the getter material therein.

In step S6, shown in Figure 5F, a functional structure 10 is provided.
The functional structure 10 is present at a carrier 50. The carrier 50, is for example a glass plate, but may otherwise be an organic substrate provided with a further barrier structure. The carrier 50 with the functional structure is attached at the side of the barrier structure 20 comprising the second inorganic layer 23 by a sealant 52.

Possible examples of sealants are for instance epoxy based, UV curable adhesives, eventually filled with a dessicant material.

According to this method the second inorganic layer is applied at the organic layer, which is already patterned with at least one recess. In this way a substantially continuous second inorganic layer is obtained. The getter material is applied in a submerged manner into the at least one recess. Accordingly, even if the manufactured electronic device is flexed, only the material of the cover contacts the functional structure, so that harmful effects due to a contact between the getter material and the functional structure are avoided. Protection by an additional adhesive layer is avoided, so that harmful substances in the presence of the functional structure can flow to the getter material unhindered.

It will be understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. In the claims the word "comprising" does not exclude other elements or steps, and the indefinite article "a" or "an" does not exclude a plurality. A single component or other unit may fulfill the functions of several items recited in the claims. The mere fact that certain measures are recited in mutually different claims does not indicate that a combination of these measures cannot be used to advantage. Any reference signs in the claims should not be construed as limiting the scope.
Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

## Claims

1. Electronic device (1), comprising a functional structure (10) protected by at least one barrier structure (20) comprising a first inorganic layer (21), an organic layer (22) and a second inorganic layer (23) facing the functional structure (10), the organic layer (22) being arranged between the first and the second inorganic layer (21, 23), the barrier structure (20) being provided with at least one recess (24) wherein a getter material (30) is submerged, the getter material (30) being separated from the organic layer (22) by the second inorganic layer (23).

2. Electronic device according to claim 1, wherein the functional structure (10) comprises at least one organic layer (16).

3. Electronic device according to claim 1, wherein the functional structure (10) is an opto-electronic structure.

4. Electronic device according to claim 1, wherein the functional structure (10) is an electro-optic structure.

5. Electronic device according to claim 1, further comprising a further barrier structure (120) arranged at a side of the functional structure (10) opposite to the side of the barrier structure (20), the barrier structure (20) and the further barrier structure (120) being coupled together by a perimeter sealant (52), the barrier structure (20), the further barrier structure (120) and the perimeter sealant (52) encapsulating the functional structure (10).

6. Method for manufacturing an electronic device, comprising the steps of
- providing at least one patterned barrier structure by the steps of
- providing a first inorganic layer (S1),
- providing an organic layer having at least one recess (S2, S3),
- providing a second inorganic layer at the organic layer (S4),
- accommodating a getter material in a submerged manner into the at least one recess (S5),
- providing a functional structure at the side of the barrier structure comprising the second inorganic layer (S6).

7. Method according to claim 6, further comprising the step of providing a further barrier structure at a side of the functional structure opposite to the side of the barrier structure, and encapsulating the functional structure by the barrier structure, the further barrier structure and a perimeter sealant that couples the barrier structure and the further barrier structure.
